Europäisches Patentamt

European Patent Office

Office européen des brevets

(19)

(11) Veröffentlichungsnummer: **0 199 114 B1**

(12) **EUROPÄISCHE PATENTSCHRIFT**

(45) Veröffentlichungstag der Patentschrift: **29.04.92**

(21) Anmeldenummer: **86103975.8**

(22) Anmeldetag: **22.03.86**

(51) Int. Cl.⁵: **C04B 41/51, C23C 14/04, C23C 16/04, H01L 21/48**

(54) **Herstellung metallischer Strukturen auf anorganischen Nichtleitern.**

(30) Priorität: **16.04.85 DE 3514094**

(43) Veröffentlichungstag der Anmeldung:
**29.10.86 Patentblatt 86/44**

(45) Bekanntmachung des Hinweises auf die
Patenterteilung:
**29.04.92 Patentblatt 92/18**

(84) Benannte Vertragsstaaten:
**DE FR GB IT**

(56) Entgegenhaltungen:
**DE-A- 2 139 297**
**DE-A- 3 019 583**
**DE-A- 3 334 419**
**GB-A- 1 124 894**

(73) Patentinhaber: **SCHERING AKTIENGESELL-
SCHAFT Berlin und Bergkamen
Müllerstrasse 170/178 Postfach 65 03 11
W-1000 Berlin 65(DE)**

(72) Erfinder: **Suhr, Harald, Prof. Dr. rer. nat.
Weissdornweg 2
W-7400 Tübingen(DE)**
Erfinder: **Feurer, Ernst
Ringstrasse 6
W-7400 Tübingen(DE)**
Erfinder: **Oehr, Christian
Wintergasse 6
W-7403 Reusten(DE)**

**Beschreibung**

Die Erfindung hat zur Aufgabe, metallische Strukturen auf anorganischen, nichtleitenden Oberflächen mit physikalischen Methoden, das heißt ohne die Verwendung wäßriger Ätz- und Aktivierungslösungen herzustellen. Dabei ist es ein besonderes Merkmal der Erfindung, daß die Strukturen, die man erhalten will, im Positiv-Druck bzw. als Positiv-Bild auf die Substratoberfläche aufgebracht werden können. Es handelt sich also um ein grundsätzlich anderes Verfahren als bekannte Methoden, bei denen die Oberflächenteile, die einen Metallüberzug erhalten sollen, nicht abgedeckt werden, das Substrat also mit einer Negativ-Maske versehen wird.

Mit Hilfe der Erfindung ergeben sich neue Wege zur Herstellung von gedruckten Schaltungen, insbesondere von Feinleiterschaltungen und Mehrlagenschaltungen in der Elektronik, aber auch von Strukturen, Ornamenten u.ä. für dekorative Zwecke.

Die Durchführung der Erfindung erfolgt in folgenden Schritten:

1) Abdecken des Substrates mit einer Abdeckmaske, mit Fotolacken oder mit Siebdrucklacken im Positiv-Verfahren.

2) Einbringen in eine Glimmentladungszone unter Einwirkung von reaktiven halogenhaltigen Gasen.

3) Entfernen derAbdeckmaske bzw. des Abdecklackes.

4) Metallisieren des Substrates durch übliche Methoden wie Bedampfen, Kathodenzerstäubung (Sputtern), Plasmametallisierung.

5) "Entwickeln" der gewünschten Strukturen durch Tauchen des Substrates in Wasser oder wäßrige Lösungen von Metall-Komplexbildnern bzw. anorganischen und/oder organischen Verbindungen.

Während der Einwirkung von halogenhaltigen Gasen im Plasma entstehen auf den nichtabgedeckten Flächen des Substrates reaktive Halogenverbindungen. Überraschenderweise bilden sie bei der anschließenden physikalischen Metallbeschichtung lösliche Metallhalogenide, die durch einfache Tauchprozesse abgelöst werden können, so daß die Metallisierung nur an den Stellen erhalten bleibt, die bei der Plasmabehandlung abgedeckt waren.

Die reaktiven Halogenverbindungen, die sich während der Plasmabehandlung bilden, sind bemerkenswert stabil. Sie werden zum Beispiel durch das Anlegen eines Vakuums bei einer anschließenden Bedampfung nicht entfernt und sind auch nach tagelanger Lagerung noch voll wirksam, so daß ein sicherer Arbeitsablauf bei der Herstellung von Strukturen nach dem erfindungsgemäßen Verfahren gewährleistet ist.

Die mit dem erfindungsgemäßen Verfahren erhaltenen Strukturen können mit bekannten Methoden verstärkt werden, vorzugsweise durch eine anschließende chemische Verkupferung oder chemische Vernicklung in Bädern zur autokatalytischen Metallabscheidung.

Als Substrate, auf denen die metallischen Strukturen erzeugt werden sollen, kommen alle üblichen anorganischen Nichtleiter in Frage, insbesondere Aluminiumoxidkeramiken, Siliziumoxidkeramiken und Glas, aber auch Metalle mit Oxidschichten, wie zum Beispiel Aluminium.

Die am besten geeigneten halogenhaltigen Gase sind Bortrichlorid, Siliciumtetrachlorid, Bortrifluorid und Tetrachlorkohlenstoff.

die folgenden Beispiele erläutern die Erfindung:

BEISPIEL 1

Herstellung von Strukturen auf Aluminiumoxidkeramik durch Bedampfen mit Gold

Auf Keramikplättchen der Größe 50 x 50 x 2 mm wird das gewünschte Leiterbahnenbild mittels eines Siebdrucklackes oder nach anderen üblichen Verfahren aufgetragen.

Die Plättchen werden in einem Plasma-Reaktor einer Plasma-Einwirkung unter folgenden Bedingungen ausgesetzt:

| | |
|---|---|
| Elektrodentemperatur | 150°C |
| Frequenz | 13,56 MHz |
| Leistungsdichte | 1,6 Watt/cm$^2$ |
| Druck im Reaktor | 0,5 hPa |
| Reaktionsgas | Bortrichlorid |
| Trägergas | Argon |
| Einwirkungszeit im Plasma | 90 Minuten |

Nach Beendigung der Plasmaeinwirkung werden die Keramikplättchen aus dem Reaktor entfernt, der auf ihnen befindliche Siebdrucklack wird durch Tauchen in geeignete organische Lösemittel abgelöst.

Die Plättchen werden nun in einem handelsüblichen Gerät zur Vakuumbedampfung mit Gold bedampft. An den Stellen, die vorher nicht mit Lack abgedeckt, also dem Plasma ausgesetzt waren, wird hierbei das Gold in eine wasserlösliche Verbindung überführt. Nach dem Bedampfen werden die Plättchen in Wasser getaucht, wobei sich die Goldverbindung löst und die gewünschten Strukturen als Goldfilm auf der Oberfläche zurückbleiben.

BEISPIEL 2

Herstellung von Strukturen auf Siliziumoxidkeramik durch Bedampfen mit Kupfer

Plättchen aus Siliziumoxidkeramik der Abmessungen 80 x 40 x 3 mm werden mit Masken der gewünschten Strukturen abgedeckt und einer Plasmaeinwirkung unter gleichen Bedingungen wie im Beispiel 1 ausgesetzt. Danach werden die Plättchen aus dem Reaktor genommen, die Masken werden entfernt.

Durch Kathodenzerstäubung werden die Oberflächen auf bekannte Weise mit Kupfer beschichtet.

Danach werden die Plättchen in ein 5%ige Lösung von Ammoniak in Wasser getaucht. Hierbei wird die Kupferschicht an den Stellen, die vorher dem Plasma ausgesetzt waren, entfernt. Auf den Plättchen bleiben die durch die Masken vorgegebenen Strukturen zurück.

Sie können anschließend, wenn gewünscht, in einem chemischen Kupferbad verstärkt werden; hierbei ist keine zusätzliche Aktivierung, zum Beispiel durch Tauchen in edelmetallhaltige Lösungen, erforderlich.

Zu gleichen Ergebnissen kommt man, wenn man die Plättchen statt mit Kupfer mit Silber beschichtet. Auch hier wird das Silber bei der anschließenden Tauchung in Ammoniaklösung an den Stellen als Komplexverbindung entfernt, die während der Plasmaeinwirkung nicht abgedeckt waren.

**Patentansprüche**

1.  Verfahren zur Herstellung von metallischen Strukturen auf anorganischen, nichtleitenden Oberflächen,dadurch gekennzeichnet, daß
    - mit Hilfe von Masken, Lacken oder anderen Abdeckmitteln die gewünschten Strukturen auf der Oberfläche erzeugt werden,
    - die so behandelten Gegenstände in einer Glimmentladungszone der Einwirkung von reaktiven, halogenhaltigen Gasen ausgesetzt werden,
    - nach Beendigung der Einwirkung das Abdeckmittel entfernt wird,
    - die Gegenstände mit bekannten physikalischen Methoden metallisiert werden,
    - die Gegenstände nach dieser Metallisierung zur Herstellung der gewünschten Strukturen in Wasser oder wäßrigen Lösungen von Komplexbildnern, Säuren, Alkalien oder Stoffen, die die entstandene Metallhalogenid-Verbindung lösen, gebracht werden.

2.  Verfahren gemäß Anspruch 1, dadurch gekennzeichnet, daß als halogenhaltiges Gas Bortrichlorid, Siliciumtetrachlorid, Bortrifluorid oder Tetrachlorkohlenstoff benutzt wird.

3.  Verfahren gemäß Anspruch 1, dadurch gekennzeichnet, daß die Metallisierung der Gegenstände durch Bedampfen, Kathodenzerstäubung oder Plasma-Metallabscheidung erfolgt.

4.  Verfahren gemäß Ansprüchen 1 bis 3, dadurch gekennzeichnet, daß die metallischen Strukturen durch Behandlung in chemischen (autokatalytischen) Bädern zur Metallabscheidung verstärkt werden.

5.  Verfahren gemäß Ansprüchen 1 und 4, dadurch gekennzeichnet, daß die Herstellung der Strukturen nach dem physikalischen Metallisieren direkt durch Tauchen in das chemische Bad zur Metallabscheidung erfolgt.

**Claims**

1.  Method for the production of metallic patterns on inorganic, non-conductive substrates, characterized in that

- the desired patterns are produced on the substrate with the help of masks, varnishes or other resists,
- the objects treated in this way are exposed to the effect of reactive halogen-containing gases in a glow discharge zone,
- the resist is removed after treatment,
- the objects are metal-plated by already published physical methods,
- after this metal-plating process the objects are immersed in water or aqueous solutions of complexing agents, acids, alkalis or substances which dissolve the metal-halogen compound produced, in order to form the required patterns.

2. Method in accordance with Claim 1, characterized in that the halogenated gas used may be boron trichloride, silicon tetrachloride, boron trifluoride or carbon tetrachloride.

3. Method in accordance with Claim 1, characterized in that metal-plating of the objects takes place by evaporation, cathode sputtering or plasma metal deposition.

4. Method in accordance with Claims 1 to 3, characterized in that the metallic patterns are reinforced by treatment in chemical (autocatalytic) metal-plating baths.

5. Method in accordance with Claims 1 to 4, characterized in that the patterns are produced after physical metal-plating directly by immersion in the chemical metal-plating bath.

**Revendications**

1. Procédé de fabrication de structures métalliques sur des surfaces inorganiques non conductrices, caractérisé en ce que:
   - l'on produit les structures désirées sur la surface à l'aide de caches, vernis ou autres résistes,
   - les objets ainsi traités sont exposés dans une zone de décharge d'effluves à l'action de gaz réactifs, contenant un halogène,
   - l'on enlève les résistes lorsque l'exposition est terminée,
   - l'on métallise les objets par des méthodes physiques connues,
   - l'on immerge les objets, pour produire les structures désirées, après cette métallisation, dans l'eau ou dans des solutions aqueuses de complexants, acides, alcalis ou substances susceptibles de dissoudre le composé halogénure-métal.

2. Procédé suivant revendication 1, caractérisé en ce que l'on utilise comme gaz halogéné du trichlorure de bore, du tétrachlorure de silicium, du trifluorure de bore ou du tétrachlorure de carbone.

3. Procédé suivant revendication 1, caractérisé en ce que la métallisation des objets s'effectue par dépôt en phase vapeur, pulvérisation cathodique ou dépôt de métal dans un plasma.

4. Procédé suivant revendications 1 à 3, caractérisé en ce que les structures métalliques sont renforcées par traitement dans des bains chimiques (autocatalytiques) pour le dépôt de métal.

5. Procédé suivant revendications 1 et 4, caractérisé en ce que la production des structures s'effectue après métallisation physique directement par immersion dans le bain chimique pour le dépôt métallique.